# EUROPÄISCHE PATENTSCHRIFT

(11) **EP 0 752 760 B1**
(45) Veröffentlichungstag und Bekanntmachung des Hinweises auf die Patenterteilung: **02.09.1998**
(21) Anmeldenummer: 96110373.6
(22) Anmeldetag: 27.06.1996
(51) Int. Cl.: H03M 13/12

(54) **Punktierender Faltungsencoder ohne Zwischenspeicher und Taktumsetzer, sowie Faltungsdecoder**
Puncturing convolutional encoder and depuncturer, both without FIFO buffer and rate conversion
Encodeur convolutif à poinçonnage et dépoinçonneur, ne comprenant ni registre FIFO ni convertisseur de cadencement

(30) Priorität: 06.07.1995 DE 19524556
(43) Veröffentlichungstag der Anmeldung: 08.01.1997
(73) Patentinhaber: ROBERT BOSCH GMBH, 70442 Stuttgart (DE)
(72) Erfinder: Auer, Erich, Dr., 74354 Besigheim (DE)

(56) Entgegenhaltungen:
- EP-A- 0 301 161
- US-A- 4 908 827
- US-A- 4 939 734

## Beschreibung

Die betrifft eine Anordnung zur Codierung eines punktierten Faltungscodes sowie eine Anordnung zur Decodierung.

### Stand der Technik

Zur Erzeugung eines punktierten Faltungscodes wird meist ein Faltungsencoder der Rate 1/2 benutzt, dessen Ausgangssignale einem Bit-Selektor mit entsprechender Punktierungvorschrift zugeführt werden (IEEE-Transactions on Communications, Volume COM-32, No. 3, March 1984, Seiten 315 - 319; GB 2095517-A; Abstracts of the 6th Int. Conference on Digital Satellite Communications, Phoenix, Arizona, Sept. 1983, Seiten XII/24 - 31).

Aus der EP 301 161 A2 ist ein Verfahren zur Aufbereitung eines Faltungscodes bekannt, wobei ebenfalls eine Codepunktierung angewendet wird. Es sind dort Mittel zur Datenumordnung mittels FIFOs (First-In-First-Out) und zur Parallel-Serienwandlung vorgesehen.

### Vorteile der Erfindung

Mit den Maßnahmen des Patentanspruchs 1 läßt sich ein Faltungscode erzeugen, ohne Zuhilfenahme einer physikalischen Taktumsetzung entsprechend der Codepunktierungsrate. Im Gegensatz zu den eingangs genannten Realisierungen sind für die Punktierung keine FIFO-Register notwendig, die ein asynchrones Zeitverhalten aufweisen. Durch die streng synchrone Verarbeitung ist die Anordnung nach der Erfindung mit weiteren digitalen Baugruppen problemlos integrationsfähig. Die Codepunktierungsrate kann durch ein von außen zugeführtes Bitwort auf einfache Weise geändert werden, ohne daß die Hardwarestruktur Faltungsencoder geändert werden muß.

Auch für die Depunktierung gemäß Anspruch 7 sind keine FIFO-Register notwendig.

### Zeichnungen

Anhand der Zeichnungen werden nun bekannte und erfindungsgemäße Faltungscoderstrukturen näher erläutert. Es zeigen:
Figur 1 eine herkömmliche Struktur zur Codierung eines punktierten Faltungscodes,
Figur 2 das Prinzips eines Viterbi-Encoders und Decoders mit Punktierung,
Figur 3 eine erfindungsgemäße Struktur zur Erzeugung eines codierten punktierten Faltungscodes,
Figur 4 die für verschiedene Punktierungsraten zu streichenden Symbole,
Figur 5 die zeitliche Abarbeitung für verschiedene Codepunktierungsraten,
Figur 6 ein Blockdiagramm für einen erfindungsgemäßen Viterbi-Encoder und Punktierer,
Figuren 7 bis 11 Wahrheitstabellen für die Konfiguration des Viterbi-Encoders in Abhängigkeit einer Steuerinformation,
Figuren 12 bis 16 die Funktionen der Multiplexschalter in Abhängigkeit ihrer Schaltsignale,
Figuren 17 bis 22 die zeitliche Lage des Eingangsdaten-Bitstromes,
Figur 23 eine Chiprealisierung unter Einbindung des Faltungsencoders nach der Erfindung,
Figur 24 eine herkömmliche Struktur zur Depunktierung,
Figur 25 eine erfindungsgemäß FIFO-lose Struktur zur Depunktierung und
Figur 26 die Stellen, die durch die Depunktierung eingefügt werden.

### Beschreibung

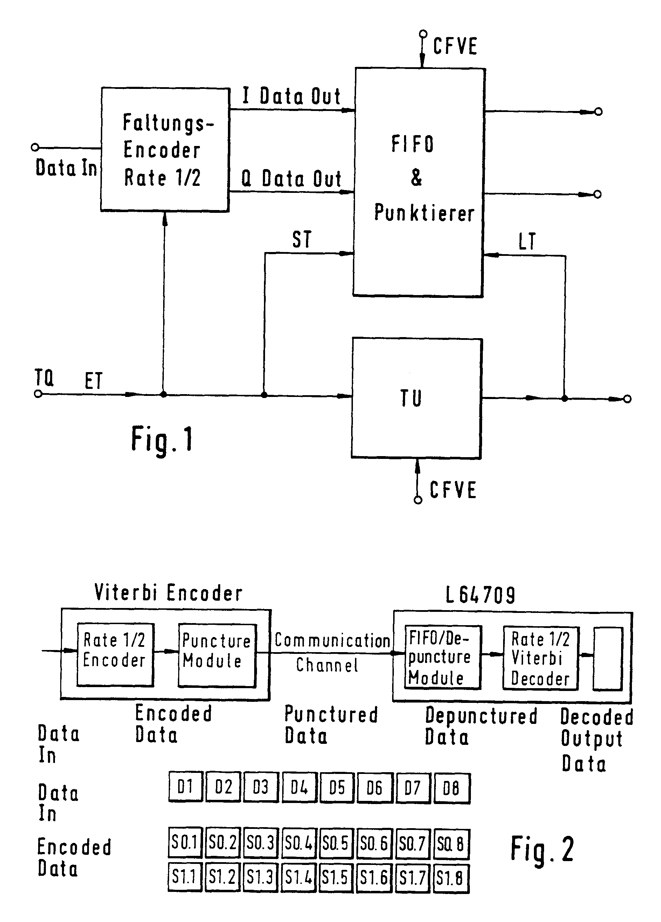

Zuerst wird zum besseren Verständnis in Figur 1 eine herkömmliche Faltungsencoder-Struktur vorgestellt. Die zu punktierenden Eingangsdaten (Data In) werden einem Faltungsencoder der Rate 1/2 zugeführt. Dieser Faltungsencoder arbeitet mit einem Eingangstakt ET einer Taktquelle TQ. Die I- und Q-Faltungsencoder-Ausgangsdatenströme - I Data Out und Q Data Out - werden einem FIFO zur Punktierung zugeführt, dessen Schreibtakt ST dem Eingangstakt ET entspricht. Als Steuerinformation für die gewünschte Codepunktierungsrate R wird dem FIFO ein externes Bitwort CFVE (Configuration for Viterbi Encoder) zugeführt. Da das Auslesen des FIFO mit einem Lesetakt LT zu erfolgen hat, der von der Codepunktierungsrate R abhängig ist, muß zu Generierung des Lesetaktes LT eine Taktumsetzung - Stufe TU - erfolgen, die von der Steuerinformation für die gewünschte Codepunktierungsrate R = n/(n+1) ; n = 1,2,... abhängig ist. Dieser Lesetakt LT bildet auch den kontinuierlichen Ausgangstakt des Encoders, der für weitere Zwecke, z.B. zur Synchronisierung weiterer Baugruppen benötigt wird.

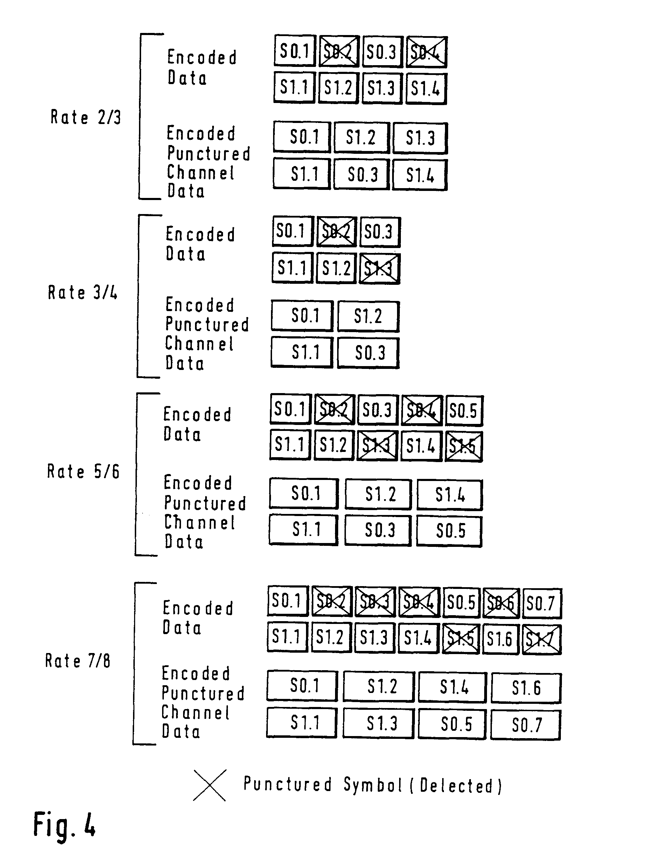

Figur 2 zeigt ein schematisches Prinzip eines Viberbi-Encoder/Decoders mit einem sendeseitigen Punktierungsmodul (Puncture Module) und einem entsprechenden empfangsseitigen Depunktierungsmodul (FIFO/Depuncture Module). Darunter sind die Eingangsdaten (Data In) D1 ... D8 für ein acht Bit breites Wort dargestellt und darunter die durch den Viberbi-Encoder codierten Dibits (Encoded Data) S0.1, S1.1, S0.2, S1.2, usw. bis S0.8, S1.8. Die Coderate in Abhängigkeit des Punktierungsmusters (Puncture Pattern) ist in Figur 4 dargestellt.

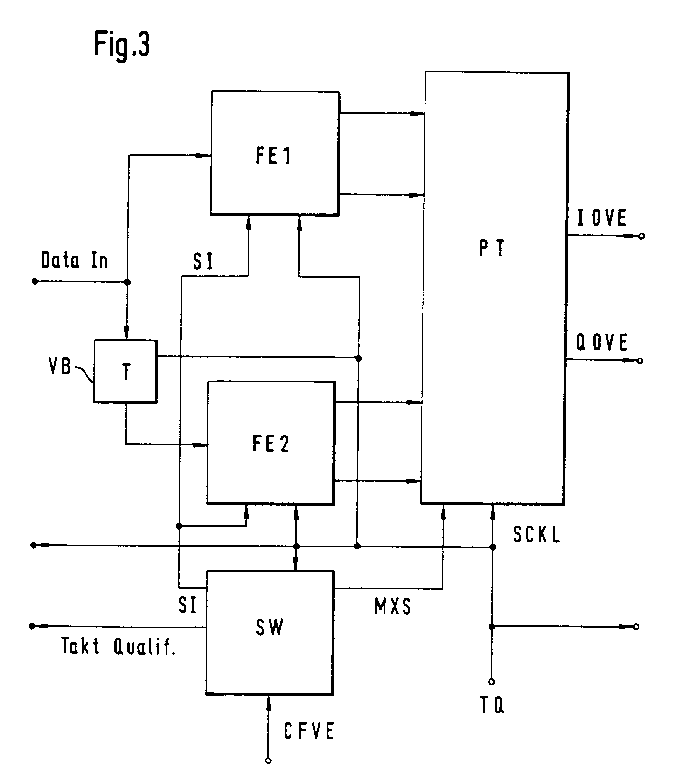

Figur 3 zeigt eine erfindungsgemäße Faltungsencoder-Struktur mit zwei parallel betreibbaren Faltungsencoder-Bausteinen FE1 und FE2 der Codierrate 1/2. Natürlich können auch allgemein m parallel betreibbare Faltungsencoder-Bausteine mit jeweils der Codierrate 1/m verwendet werden. Die dargestellte Struktur stellt nur eine mögliche Minimalstruktur dar. Die beiden Faltungsencoder-Bausteine FE1 und FE2 sind in der Lage, gesteuert durch das Steuerwerk SW, entweder um eine Bitposition - Zeitversatz T - oder um zwei Bitpositionen - Zeitversatz 2T - die Eingangsdaten zu schieben, d.h. um T oder 2T zeitlich gegeneinander zu versetzen. Die Eingangsdaten Data In bzw. DIVE (Data Input to Viterbi-Encoder) werden dem Faltungsencoder-Baustein FE1 direkt und dem Faltungsencoder-Baustein FE2 um eine Bitposition verzögert zugeführt. Dazu ist der Verzögerungsbaustein VB vorgesehen. Die Ausgangsdaten der beiden Faltungsencoder-Bausteine FE1 und FE2 in Form von Dibit-Kombinationen werden anschließend einem Punktierer PT in Form einer Multiplexlogik, d.h. einer gesteuerten Auswahlschaltung zugeführt, die in Abhängigkeit eines vom Steuerwerk SW aufbereiteten Multiplex-Steuersignals MXS und dem von der Taktquelle TQ gelieferten Taktsignal SCKL in (Symbol Clock) die punktierten I- und Q- Faltungsencoder-Datenströme IOVE und QOVE erzeugt. Die Steuerinformation für die gewünschte Codepunktierungsrate R ist wieder mit CFVE bezeichnet. Das Steuerwerk SW liefert außerdem eine Schiebesteuerinformation SI für die beiden Faltungsencoder-Bausteine FE1 und FE2.

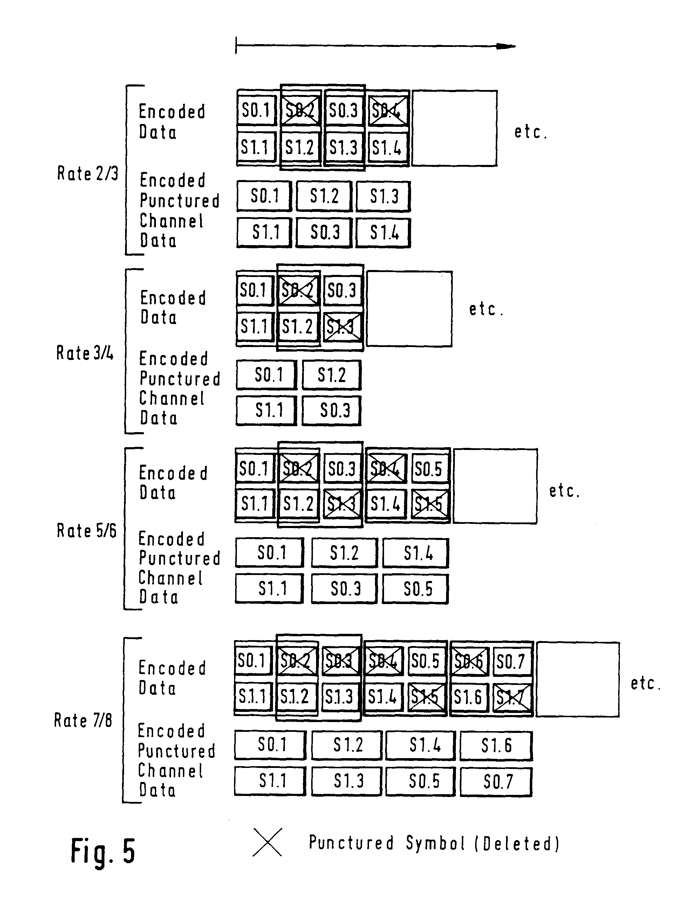

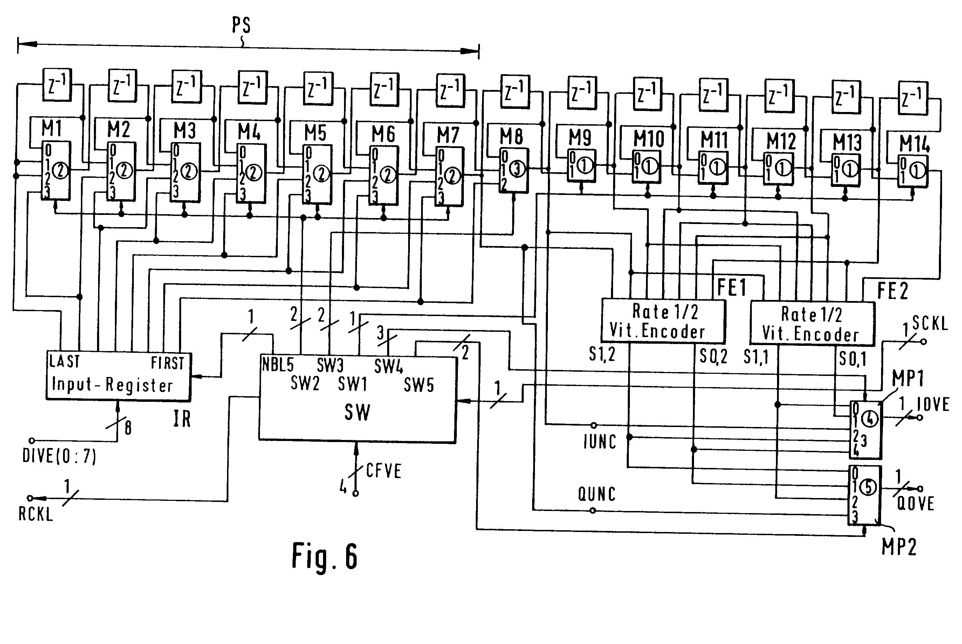

Zum byteweisen Lesen der Daten aus einem Interleaver in ein oder mehrere Eingangsregister des Faltungsencoders ist im Prinzip für jede Codepunktierungsrate R ein entsprechendes Schaltverbindungsschema zu ermitteln. Mit jedem Zählzyklus Z des Symboltaktes SCKL wird hierbei eine bestimmte Zahl von Eingangsbits (1 oder 2) benötigt. Damit kann ermittelt werden, wann ein neues Byte aus dem Speicher des Interleavers zu holen ist und in welcher Form dieses Byte an das vorherige anzuhängen ist. Welche Symbole S für die Punktierung mit den Raten 2/3, 3/4, 5/6, 7/8 zu streichen sind, zeigt Figur 4. Figur 5 veranschaulicht die zeitliche Abarbeitung für verschiedene Codepunktierungsraten, d.h. die Verschiebung um eine bzw. zwei Bitpositionen (in der Figur jeweils umrahmt). Ein mögliches Ausführungsbeispiel eines Viterbi-Encoders und Punktierers hierzu zeigt Figur 6.

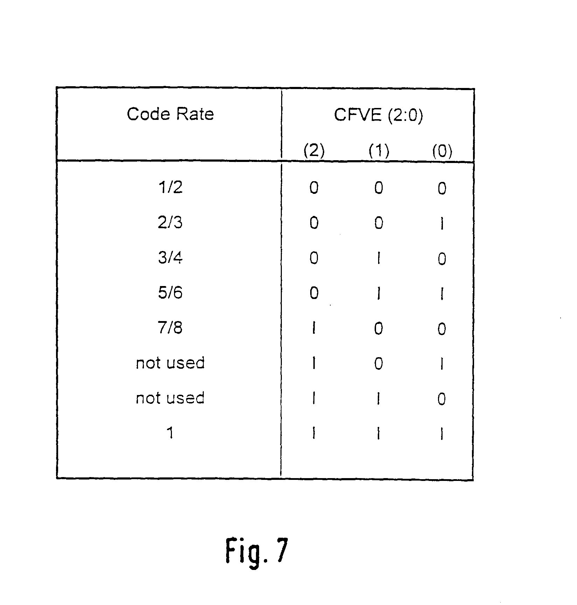

Die Eingangsdaten DIVE der Wortbreite 8 Bit werden in das Eingangsregister (Input Register) in Abhängigkeit des Steuersignals NBLS (Next Byte Load Strobe) vom Steuerwerk SW byteweise eingelesen. Die Verzögerungszellen zur Signalverzögerung um die Zeit T sind mit Z⁻¹ bezeichnet. In Abhängigkeit des vom Steuerwerk SW gelieferten Schaltsignals SW1 nehmen die Multiplexschalter M1 bis M7 jeweils einen von vier verschiedenen Schaltzuständen 0 ... 3 ein. Die Verknüpfung ist derart, daß eine Parallel-Serienwandlung PS der Eingangsdaten DIVE erfolgt. Die Schiebesteuerung und die Taktversorgung der Faltungsencoder-Bausteine FE1 und FE2 erfolgt über die Multiplexschalter M8 bis M14, Auswahlschalter mit drei bzw. zwei Schaltstellungen in Abhängigkeit der Schaltsignale SW3 und SW1. Die Ausgangsbitpaare S1;2, S0;2 und S1;1, S0;1 der beiden Faltungsencoder-Bausteine FE1 und FE2 werden zur Punktierung über die Multiplexlogik in Form der beiden Multiplexschalter MP1 und MP2 (Auswahlschalter 1 aus 4 bzw. 1 aus 5) geführt. Die Steuerung der Multiplexschalter MP1 und MP2 erfolgt über die Schaltsignale SW4 und SW5 des Steuerwerks SW. Die Konfigurationen und die Steuerung sind aus den Wahrheitstabellen zu entnehmen. Es zeigen im einzelnen: Figur 7 die Konfiguration des Viterbi-Encoders für die verschiedenen Coderaten in Abhängigkeit der Steuerinformation CFVE (Bitwort der Breite 2:0). Für unterschiedliche Modulationsarten, z.B. BPSK oder QPSK kann die Steuerinformation CFVE um ein Bitstelle d.h. auf drei erweitert werden. Für die weiteren Wahrheitstabellen gelten folgenden Vereinbarungen:
Shift 0: Verschiebung um eine Bitposition
Shift I: Verschiebung um zwei Bitpositionen
Ts: Periode des Symboltaktes

Für die Rate 1/2 gilt:
Shift ≡ 0 I ≡ S0;1
Q ≡ S1;1.

Für die Rate 2/3 gilt:
Periodizität Z_{2/3} = 3 · Ts.

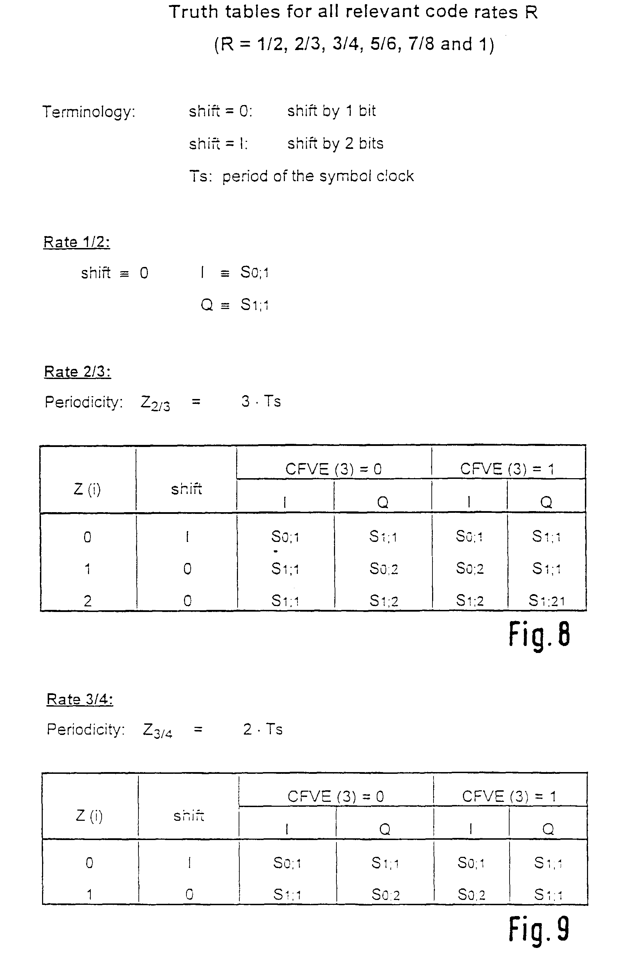

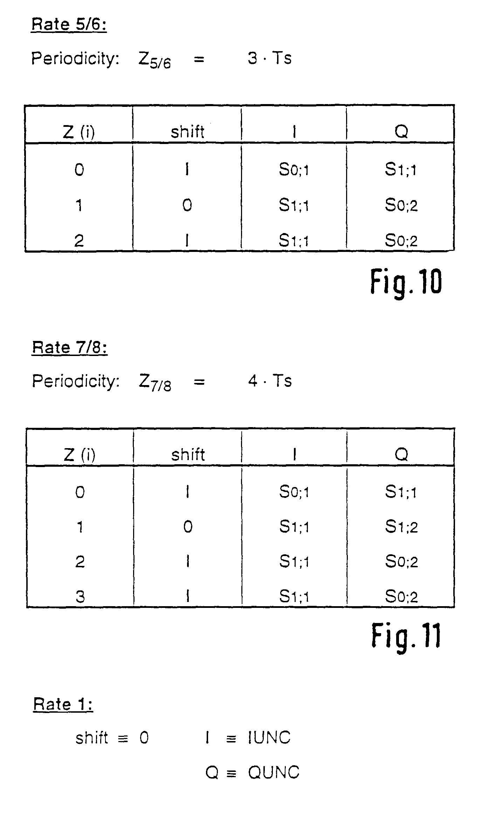

Die Wahrheitstabelle für die Steuerinformation CFVE in Abhängigkeit von Z gemäß Figur 8 gilt für die Codepunktierungsrate 2/3, wobei i = 0,1,2... ein laufender Index ist. Für die Codepunktierungsrate 3/4 mit der Periodizität Z_{3/4} = 2 · Ts gilt die entsprechende Wahrheitstabelle nach Figur 9. Für die Rate 5/6 mit Z_{5/6} = 3 · Ts gilt die Wahrheitstabelle nach Figur 10 und für die Rate 7/8 mit Z_{7/8} = 4 · Ts die Wahrheitstabelle nach Figur 11. Für die Rate 1 gilt:
Shift ≡ I I ≡ IUNC und Q ≡ QUNC.

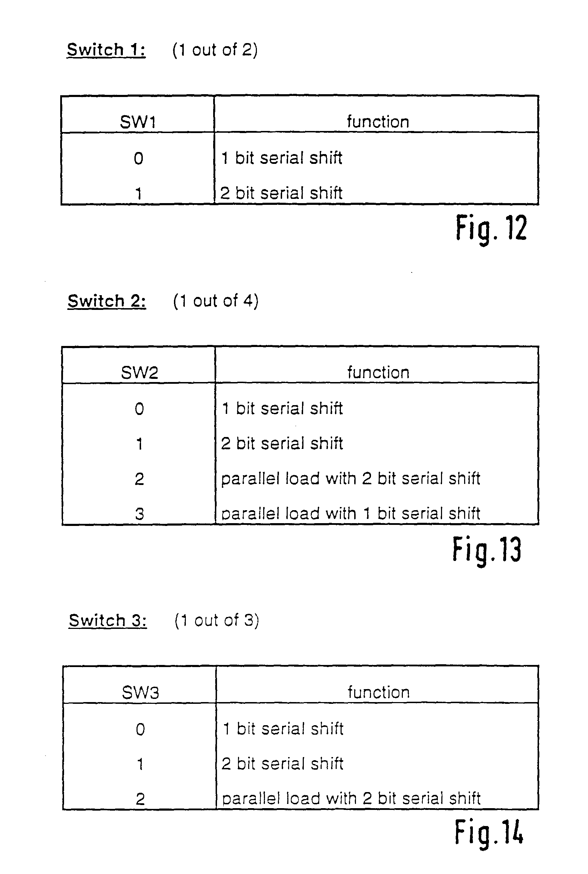

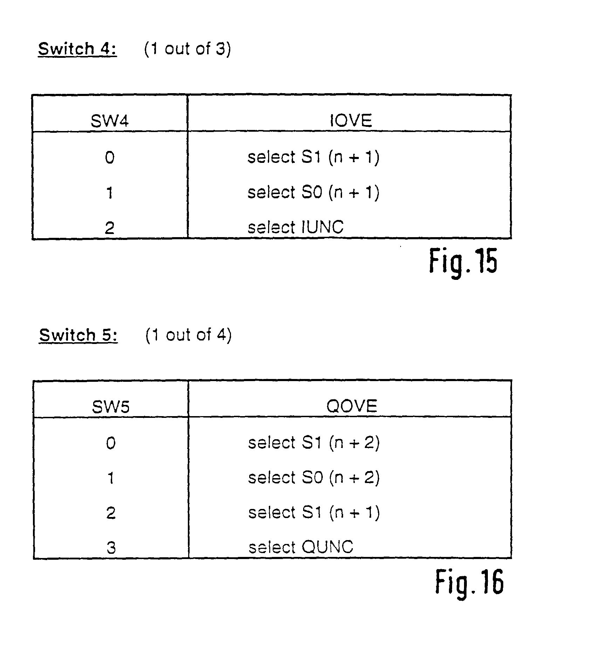

Die Figuren 12 bis 16 geben für die Multiplexschalter M1 bis M14 sowie MP1 und MP2 in Abhängigkeit ihrer Schaltsignale SB1 bis SB5 vom Steuerwerk SW die ausgeführten Funktionen (function) an. Die Multiplexschalter M9 bis M14 sind 1 aus 2 Schalter (Switch Typ 1, in Figur 6 durch Kreis markiert). Die Multiplexschalter M1 bis M7 sind 1 aus 4 Schalter (Switch Typ 2, durch Kreis markiert). Die Multiplexschalter M8 ist ein 1 aus 3 Schalter (Switch Typ 3) und die Multiplexschalter MP1 und MP2 sind 1 aus 3 bzw. 1 aus 5 Schalter. Die Funktionen in den Tabellen geben an, ob seriell geschoben (serial shift), parallel geladen (parallel load) oder welche Symbole S selektiert (select) werden.

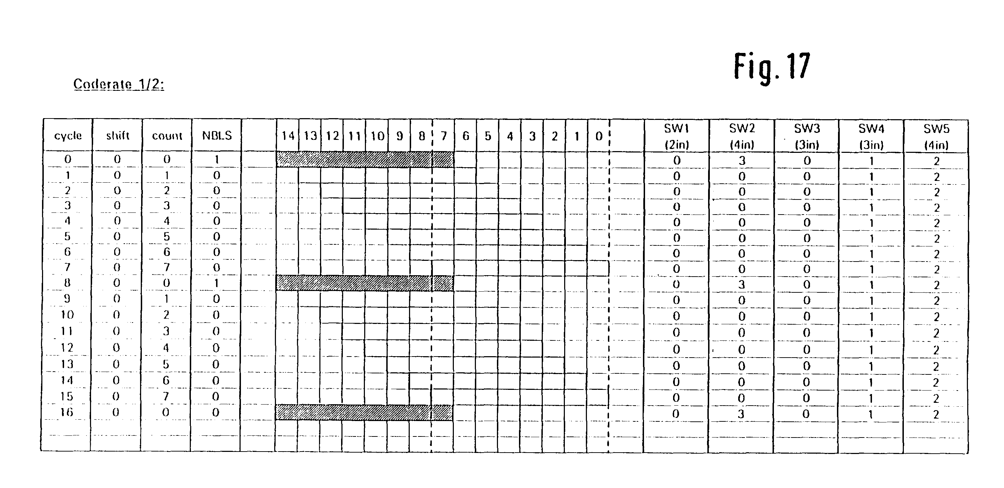

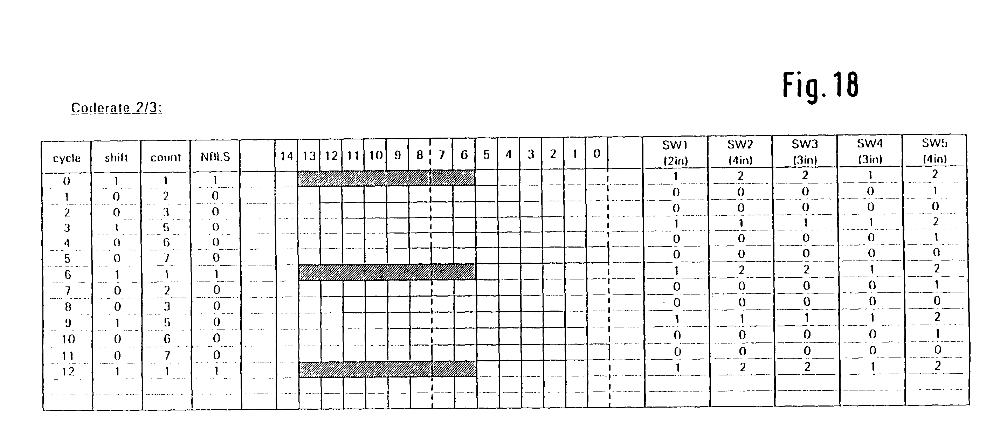

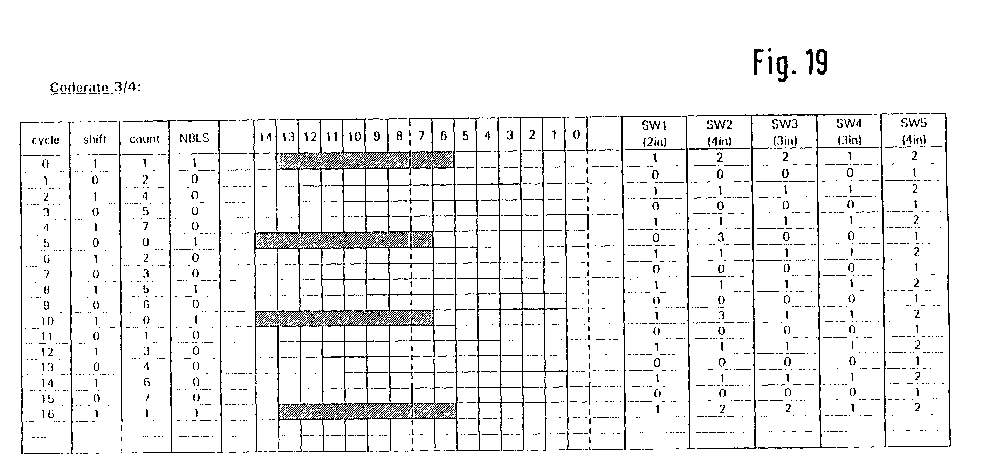

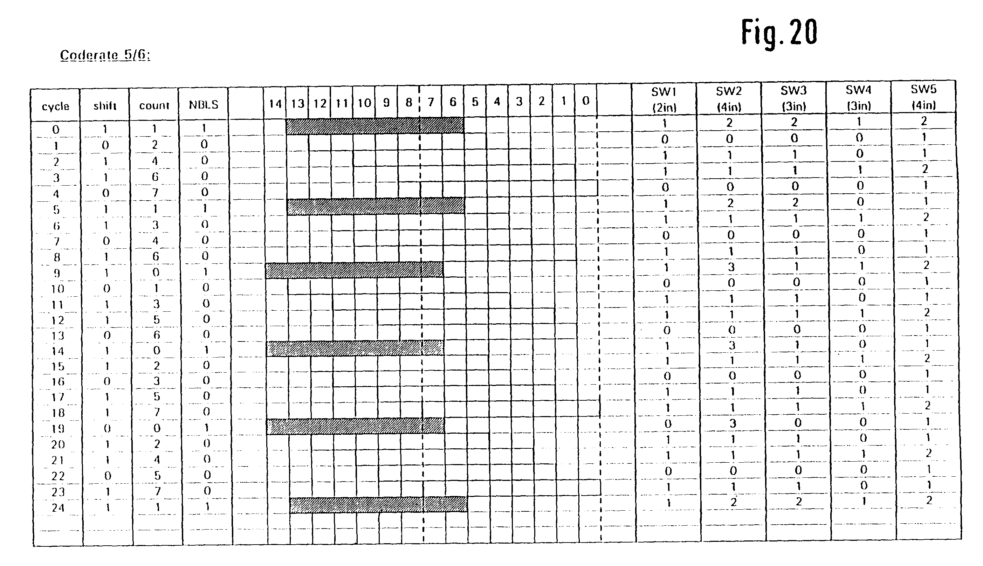

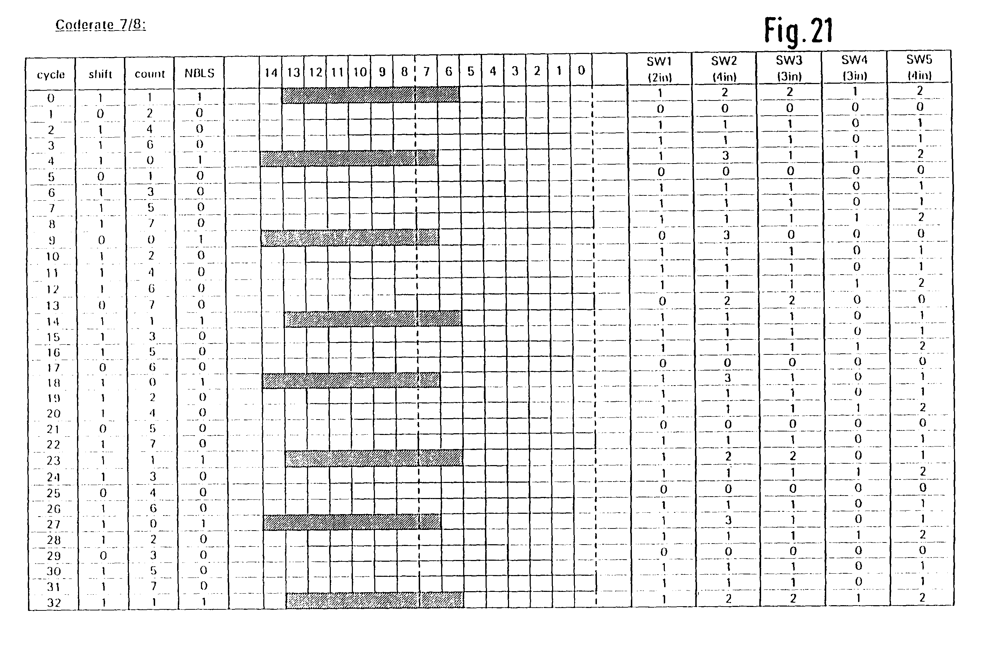

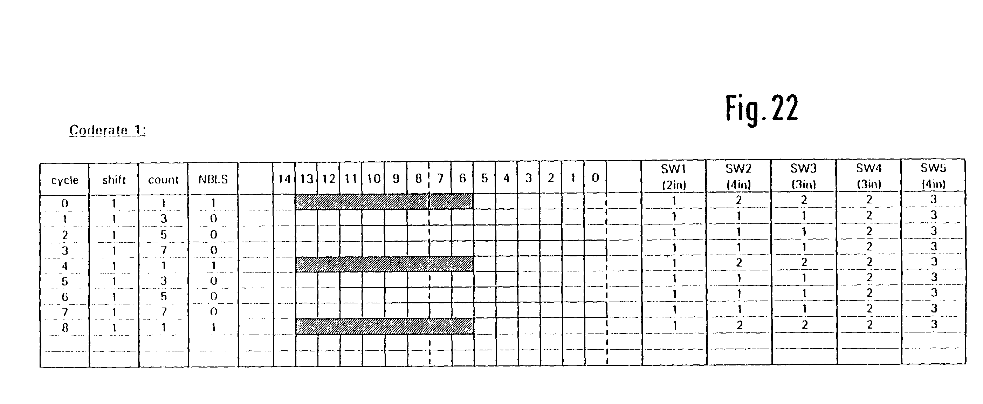

Die weiteren Figuren 17 bis 22 veranschaulichen für die zuvor gezeigten Codepunktierungsraten jeweils die zeitliche Lage des Eingangsdaten-Bitstromes (schraffiert) bezüglich der Bitpositionen 14 ... 0 jeweils während eines kompletten Zyklus (cycle) und die dazugehörige Verschiebungssteuer-Information (shift), dem Nachladebefehl (NBLS) sowie die Schaltsignale SW1 bis SW5 in Abhängigkeit der Steuerinformation CFVE.

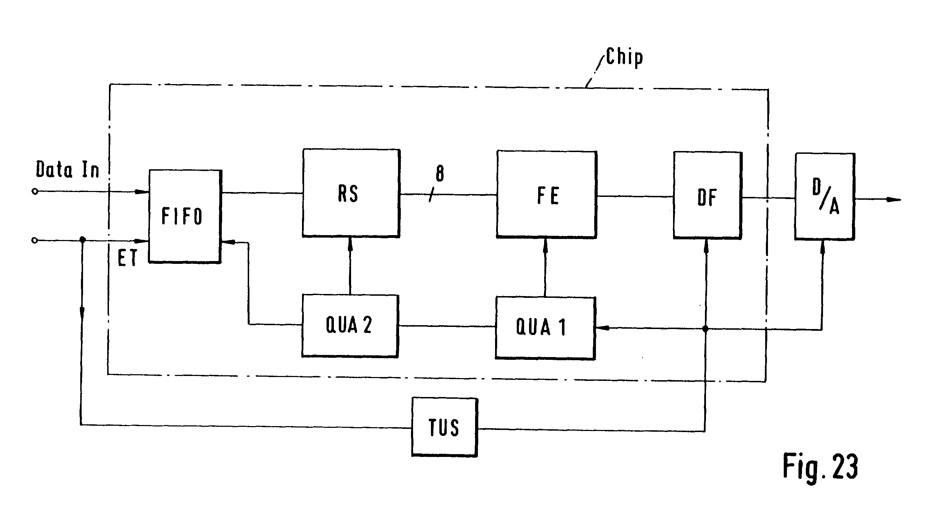

Figur 23 zeigt die Zusammenschaltung des Faltungsencoders FE mit weiteren Baugruppen: einem vorgeschalteten Reed-Solomon-Encoder RS und einem nachgeschalteten Digitalfilter DF. Diese Baugruppen können auf einem Chip integriert werden. Der sich anschließende D/A-Wandler dient zur Aufbereitung von Modulationssignalen für eine Sendeeinrichtung. Der Eingangstakt ET muß für alle Baugruppen lediglich einmal fest umgesetzt werden - Stufe TUS - und für den Faltungsencoder FE und den Reed-Solomon-Encoder RS lediglich umqualifiziert werden - Baugruppen QUA1 und QUA2. Lediglich am Chipeingang ist vor dem Reed-Solomon-Encoder RS ein FIFO vorgesehen.

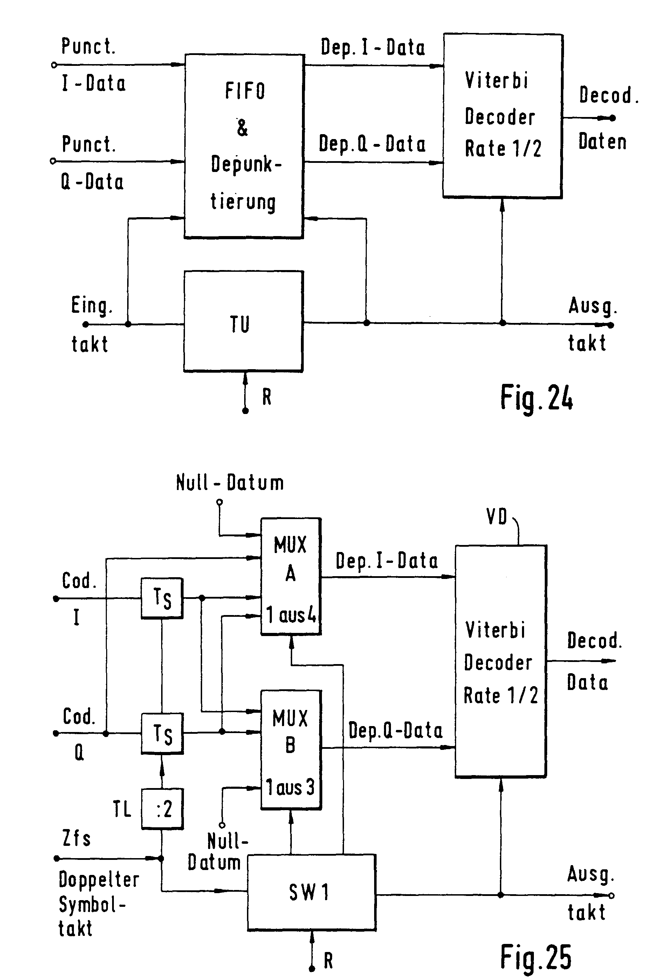

Figur 24 zeigt eine Anordnung zur Depunktierung nach dem Stand der Technik. Wie beim Punktierer ist eine Taktumsetzung zwischen Eingangs- und Ausgangstakt notwendig. Die Eingangsdaten punctured I-Data und punctured Q-Data werden einem FIFO und Depunktierbaustein zugeführt. Der Eingangstakt dient als Schreibtakt für den Depunktierer und der Ausgangstakt als Lesetakt. Die gewünschten Codepunktierungsrate R wird der Taktumsetzungsstufe TU wie auch dem Depunktierer in Form einer Steuerinformation zugeführt. Die physikalische Taktumsetzung dient dazu, den Eingangstakt entsprechend der Depunktierungsrate oder inversen Coderate R⁻¹, allgem. R⁻¹ = (n+1)/n ; n = 1,2 ..., in einen kontinuierlichen Ausgangstakt umzusetzen.

Die depunktierten Datenströme 'depunctured I-Data' und 'depunctured Q-Data' werden einem handelsüblichen Viterbi-Decoder der Rate 1/2 zugeführt, an dessen Ausgang die decodierten Daten abgreifbar sind.

In Figur 25 ist eine erfindungsgemäße FIFO-lose Struktur zur Depunktierung dargestellt. Die Eingangsdaten werden nun einmal um eine Symbolperiodendauer T_{S} verzögert bzw. unverzögert auf Multiplexschalter MUX A und MUX B geführt. Der Multiplexschalter MUX A ist ein 1 aus 4 Auswahlschalter, der in Abhängigkeit der Steuerinformation über die Codepunktierungsrate R folgende Datenströme durchschaltet:
1. Null-Datum, d.h. Nullen zur Auffüllung von zuvor bei der Punktierung ausgelassenen Bits,
2. Coded Q-Data,
3. um T_{S} verzögerte Coded I-Data
4. um T_{S} verzögerte Coded Q-Data

Der Multiplexschalter MUX-B ist ein 1 aus 3 Auswahlschalter zur Durchschaltung folgender Datenströme:
1. um T_{S} verzögerte Coded I-Data
2. um T_{S} verzögerte Coded Q-Data
3. Null-Datum.

Das Steuerwerk SW1 liefert die Steuersignale für die beiden Multiplexer MUX A und MUX B und nimmt entsprechend der eingestellten Codepunktierungsrate eine Qualifizierung des doppelten Symboltaktes 2 fs in den Ausgangstakt vor. Für die Verzögerung um die Symbolperiodendauer T_{S} wird über einen Teiler TL die Symboltaktfrequenz fs abgeleitet. Die depunktierten I und Q-Datenströme werden dann einem handelsüblichen Rate 1/2 Viterbi-Decoder VD zur Decodierung zugeführt.

Der Decoder inclusive Depunktierer liefert 3-bit quantisierte, soft-decision I und Q Daten in der Symbolperiodendauer T_{S}. Die Depunktierung besteht aus einer Einfügung des Null-Datums, das keine Decision-Information enthält. Das Einfügen der Null-Daten erfolgt nach einer zur Punktierung inversen Depunktierungsvorschrift. Als Systemtakt muß mindestens der doppelte Symboltakt zur Verfügung stehen. Der doppelte Symboltakt 2·fs ist direkt erzeugbar anstelle des einfachen Symboltakts, so daß hierdurch kein Zusatzaufwand entsteht. Eine Verschiebung des Punktierungs-Pattern als Teil der Synchronisation des Viterbi-Decoders muß vorgesehen werden. Die Depunktierungsvorschrift sowie deren Verschiebung in alle möglichen Phasenlagen ist durch ein geeignetes Schaltwerk zu implementieren.

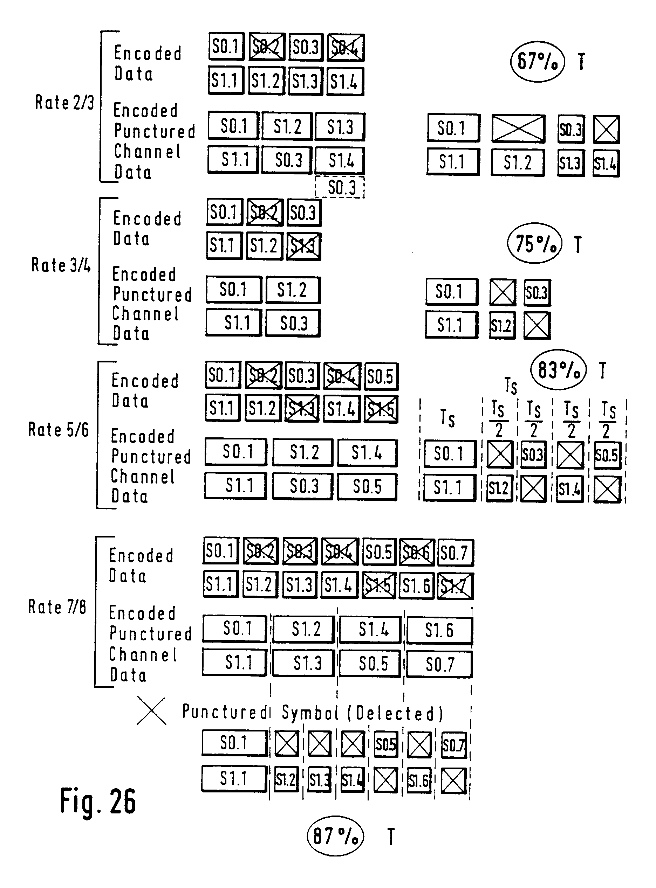

Die FIFO-lose Implementierung des Decoders stellt höhere Anforderungen an den Viterbi-Decoder bezüglich der Rechenzeit, da durch den burstartigen Betrieb die Zeit für einen Rechenschritt verkürzt wird. Wie Figur 26 zeigt, wird die zur Verfügung stehende Zeit T bis auf 67% bei Rate 2/3 verkürzt. Die gekreuzten Symbole in Figur 25 zeigen die Stellen, die durch die Null-Daten eingefügt werden.

Alle digitalen Baugruppen können in einem mit einer einzigen Taktquelle synchron getakteten Chip integriert sein.

## Patentansprüche

1. Anordnung zur Codierung eines punktierten Faltungscodes mit folgenden Baugruppen:
- einer Mehrzahl parallel betreibbarer Faltungsencoder-Bausteine (FE1, FE2) mit vorgegebener Codierrate 1/m,
- einem Steuerwerk (SW) mittels dessen aufgrund eine gewünschten Punktierungsmusters die zu punktierenden Eingangsdaten um eine von Null verschiedene gewünschte Anzahl von Bitpositionen zur Verarbeitung durch die Faltungsencoder-Bausteine (FE1, FE2) verschiebbar sind,
- einem Punktierer (MP1, MP2) in Form einer logischen Verknüpfungsschaltung mittels der in Abhängigkeit der gewünschten Codepunktierungsrate (R) die Ausgangsdaten der Faltungsencoder-Bausteine (FE1, FE2) zu den punktierten I- und Q-Faltungsencoder-Datenströmen aufbereitbar sind.

2. Anordnung gemäß Anspruch 1, gekennzeichnet durch:
- ein Register (IR) für die zu codierenden Eingangsdaten, mittels dessen in Abhängigkeit eines Ladebefehls vom Steuerwerk (SW) die Eingangsdaten byteweise parallel einlesbar sind,
- einer Stufe zur Parallel-Serienwandlung (PS) und zur Verschiebung dieser einlesbaren Daten in Abhängigkeit einer Schiebesteuerinformation vom Steuerwerk (SW) um eine Bitposition (T) oder um zwei Bitpositionen (2T),
- einen Multiplexer (MP1, MP2) an jeweils einem Ausgang eines Faltungsencoder-Bausteins (FE1, FE2), wobei dieser Multiplexer vom Steuerwerk (SW) anhand der gewünschten Codepunktierungsrate steuerbar ist.

3. Einrichtung nach Anspruch 1 oder 2, dadurch gekennzeichnet, daß der Anordnung zur Erzeugung des punktierten Faltungscodes ein Reed-Solomon-Encoder (RS) vorgeschaltet ist.

4. Faltungsencoder bzw. Anordnung nach einem der Ansprüche 1 bis 3, dadurch gekennzeichnet, daß der Anordnung bzw. der Einrichtung ein digitales Filter (TF) und ggf. ein D/A-Wandler (DA) zur Aufbereitung von Modulationssignalen für eine Sendeeinrichtung (SE) nachgeschaltet ist.

5. Faltungsencoder bzw. Anordnung nach einem der Ansprüche 1 bis 4, dadurch gekennzeichnet, daß die Taktinformation für alle Baugruppen, die eine Taktinformation benötigen, aus einer gemeinsamen Taktquelle (TQ) ohne besondere Taktanpassungsmaßnahmen abgeleitet ist.

6. Faltungsencoder bzw. Anordnung nach einem der Ansprüche 1 bis 5, dadurch gekennzeichnet, daß alle digitalen Baugruppen in einem Chip integriert sind.

7. Anordnunng zur Decodierung eines punktierten Faltungscodes mit folgenden Baugruppen:
- einer Mehrzahl parallel betreibbarer Multiplexschalter (MUX A, MUX B), welchen die zu decodierenden Datenströme (I, Q-data) unverzögert sowie um eine Symbolperiodendauer (T_{S}) verzögert zuführbar sind,
- einem Steuerwerk (SW1) mittels dessen aufgrund der gewünschten Depunktierungsrate (R⁻¹) die unverzögerten und die um eine Symbolperiodendauer (T_{S}) verzögerten Datenströme (I, Q) sowie die aufgrund der Punktierung ausgelassenen und bei der Depunktierung durch Null-Daten ersetzten Symbole zu einem Faltungsdecoder (VD) durchschaltbar sind.

## Claims

1. Arrangement for encoding a punctured convolutional code, having the following assemblies:
- a plurality of convolutional encoder modules (FE1, FE2) which can be operated in parallel and have a predetermined encoding rate 1/m,
- a control unit (SW), by means of which, on the basis of a desired puncture pattern, the input data to be punctured can be shifted by a desired number of bit positions, which number differs from zero, for the purpose of processing by the convolutional encoder modules (FE1, FE2),
- a puncturer (MP1, MP2) in the form of a logic combination circuit, by means of which, as a function of the desired code puncture rate (R), the output data of the convolutional encoder modules (FE1, FE2) can be conditioned to form the punctured I and Q convolutional encoder data streams.

2. Arrangement according to Claim 1, characterized by:
- a register (IR) for the input data to be encoded, by means of which register the input data can be read in in parallel in a byte-by-byte manner as a function of a load command from the control unit (SW),
- a stage for parallel-serial conversion (PS) and for shifting these data that can be read in, as a function of a shift control information item from the control unit (SW), by one bit position (T) or by two bit positions (2T),
- a multiplexer (MP1, MP2) at each output of a convolutional encoder module (FE1, FE2), it being possible for this multiplexer to be controlled by the control unit (SW) using the desired code puncture rate.

3. Device according to Claim 1 or 2, characterized in that a Reed-Solomon encoder (RS) is connected upstream of the arrangement for generating the punctured convolutional code.

4. Convolutional encoder and/or arrangement according to one of Claims 1 to 3, characterized in that a digital filter (TF) and, if appropriate, a D/A converter (DA) for conditioning modulation signals for a transmission device (SE) are connected downstream of the arrangement or of the device.

5. Convolutional encoder and/or arrangement according to one of Claims 1 to 4, characterized in that the clock information for all of the assemblies which require a clock information item is derived from a common clock source (TQ) without special timing alignment measures.

6. Convolutional encoder and/or arrangement according to one of Claims 1 to 5, characterized in that all of the digital assemblies are integrated in a chip.

7. Arrangement for decoding a puntured convolutional code, having the following assemblies:
- a plurality of multiplex switches (MUX A, MUX B), which can be operated in parallel and to which the data streams (I, Q data) to be decoded can be fed with no delay and also in a manner delayed by a symbol period (T_{S}),
- a control unit (SW1), by means of which, on the basis of the desired depuncture rate (R⁻¹), the undelayed data streams (I, Q) and the data steams (I, Q) delayed by a symbol period (T_{S}) as well as the symbols which have been omitted on account of the puncturing and replaced by zero data during depuncturing can be switched through to a convolutional decoder (VD).

## Revendications

1. Dispositif pour coder un code convolutif poinçonné comprenant les ensembles suivants :
- plusieurs composants de codeur convolutif (FE1, FE2) pouvant fonctionner en parallèle et ayant un taux de codage (1/m) prédéterminé,
- un dispositif de commande (SW) à l'aide duquel, à partir d'un modèle de poinçonnement souhaité, on décale les données d'entrée à poinçonner, d'au moins un nombre de positions de bit, souhaité, différent de zéro, pour le traitement par les composants de codeur convolutif (FE1, FE2),
- un poinçonneur (MP1, MP2) sous la forme d'un circuit de combinaison logique, à l'aide duquel, en fonction du taux de poinçonnement de code souhaité (R), on applique les données de sortie des composants de codeur convolutif (FE1, FE2) au flux de données poinçonnées de codeur convolutif (I et Q).

2. Dispositif selon la revendication 1,
caractérisé par
- un registre (IR) pour les données d'entrée à coder qui, en fonction d'un ordre de chargement fourni par le dispositif de commande (SW), enregistre les données d'entrée par octet en parallèle,
- un étage pour la conversion parallèle/série (PS) et le décalage des données susceptibles d'être enregistrées en fonction d'une information de commande de décalage fournie par le dispositif de commande (SW), d'une position de bit (T) ou de deux positions de bit (2T),
- un multiplexeur (MP1, MP2) à chaque sortie d'un composant de codage en multiplexage (FE1, FE2), ce multiplexeur étant commandé par le mécanisme de commande (SW) à l'aide du taux de poinçonnement de code souhaité.

3. Installation selon la revendication 1 ou 2,
caractérisée en ce que
la disposition pour générer le code convolutif poinçonné est précédée d'un codeur Reed-Solomon (RS).

4. Codeur ou décodeur convolutif selon l'une des revendications 1 à 3,
caractérisé en ce que
le dispositif ou l'installation sont suivis d'un filtre numérique (TF) et le cas échéant d'un convertisseur (D/A) (DA) pour préparer les signaux de modulation pour une installation d'émission (SE) en aval.

5. Codeur ou dispositif convolutif selon l'une des revendications 1 à 4,
caractérisé en ce que
les informations de cadence pour tous les composants qui nécessitent une information de cadence sont déduites d'une source de cadence commune (TQ) sans problème d'adaptation particulier.

6. Codeur ou dispositif convolutif selon l'une des revendications 1 à 5,
caractérisé en ce que
tous les composants numériques sont intégrés dans une plaquette.

7. Dispositif de décodage d'un code convolutif poinçonné comprenant les étapes suivantes :
- plusieurs multiplexeurs entraînés en parallèle (MUX A, MUX B) entre lesquels on applique les flux de données à décoder (données Q, données I) de manière non retardée ainsi que de façon retardée d'une durée de période symbole (TS),
- à l'aide du taux de dépoinçonnement souhaité (R⁻¹), on applique au dispositif de commande (SW1) les flux de données (I, Q) non retardées et retardées de la durée de période symbole (TS) et pour des raisons de poinçonnement les symboles éliminés et les symboles remplacés par les données zéro sont connectés à un code de convolution (VD).
